# EUROPEAN PATENT APPLICATION

(11) **EP 1 564 886 A1**
(43) Date of publication of application: **17.08.2005**
(21) Application number: 04425083.5
(22) Date of filing: 10.02.2004
(51) Int. Cl.: H03K 5/13, H03K 5/08

(54) **Time-delay circuit**

(71) Applicant: STMicroelectronics S.r.l., 20041 Agrate Brianza (Milano) (IT)
(72) Inventor: Confalonieri, Pierangelo, 20040 Caponago (Milano) (IT); Zamprogno, Marco, 20031 Cesano Maderno (Milano) (IT); Garibaldi, Federico, 20043 Arcore (Milano) (IT)
(74) Representative: Siniscalco, Fabio

(57) **Abstract**

The described circuit comprises a first stage with an inverter (INV1), a capacitor (C1) connected to the input terminal of the inverter, a constant current generator (G1) and an electronic switch (M1) controlled by an input pulse (IN). The capacitor (C1) begins to charge at a predetermined edge of the input pulse and brings the input terminal of the inverter (INV1) from a first voltage (ground) to the switching threshold voltage of the inverter, so that on the output terminal of the inverter there is obtained a pulse having an edge that, as referred to the predetermined edge of the input pulse, has a delay time that depends on the inverter threshold. With a view to obtaining a delay time substantially independent of the inverter threshold, the circuit comprises a second stage, coupled with the first, that is a dual circuit of the circuit of the first stage and has an inverter (INV2) equal to the one of the first stage. The delay time of the circuit is given by the sum of the time needed to charge the capacitor (C1) of the first stage from ground to the threshold voltage and the time needed to discharge the capacitor (C2) of the second stage from the supply voltage (VDD) to the threshold voltage. This sum is independent of the threshold values of the inverters.

## Description

The present invention relates to integrated circuits and, more particularly, to a time-delay circuit as defined in the preamble of Claim 1 hereinbelow.

In the design of integrated circuits there is often felt the need for generating digital signals that are retarded with respect to an edge of a digital input signal and to determine the time delay in an analog manner.

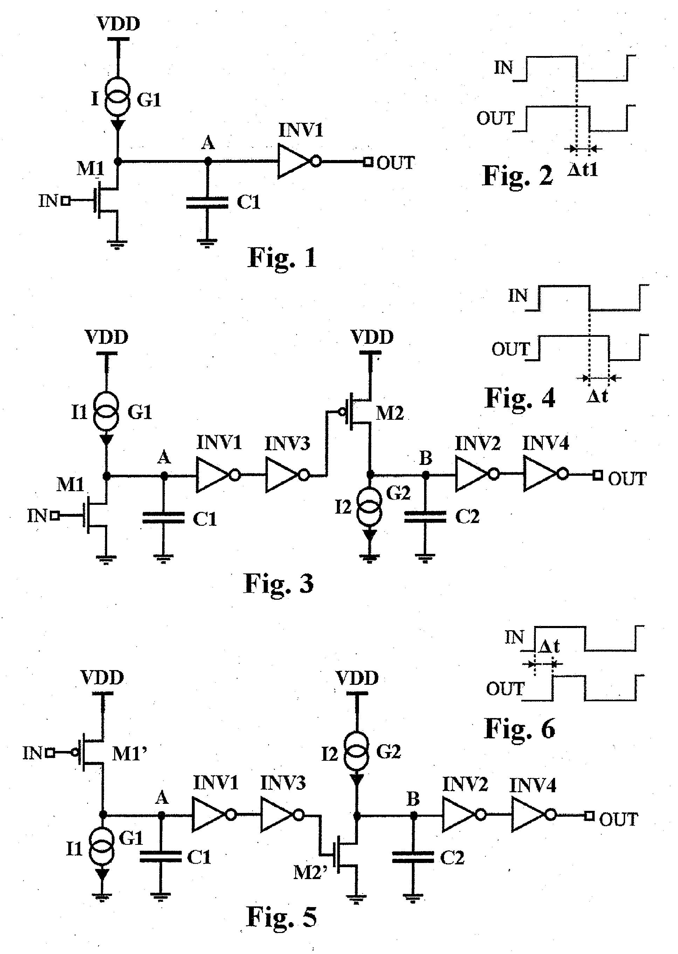

In prior art there are known circuits that respond to a predetermined edge of a binary digital input signal, i.e. to a transition from one of the predetermined binary logic states to the other, with a delay At that is a function of the ratio between a capacitance C and a current I. A time-delay circuit of this type in which the transition from 1 to 0 is retarded is schematically illustrated in Figure 1; it comprises a capacitor C1 connected to the input of an inverter INV1 and means for controlling the charge of the capacitor. These means comprise a controlled electronic switch in the form of an N-channel MOS transistor, indicated by M1, and a constant current generator G1 that are connected, in series with each other, between the terminals (VDD and ground) of a voltage supply source. More particularly, transistor M1 has its source terminal connected to ground and its drain terminal, i.e. the node A in the figure, connected to the generator G1. The input terminal IN and the output terminal OUT of the time-delay circuit are, respectively, the gate terminal of the transistor M1 and the output terminal of the inverter INV1.

Also known is the dual circuit of the one shown in Figure 1, namely a circuit that utilizes a P-channel MOS transistor having its source terminal connected to the positive terminal VDD of the supply source and its drain terminal connected, via a constant current generator, to the negative terminal of the supply source and, via a capacitor, to the positive terminal of the supply source.

As far as the biasing of the capacitor is concerned, it is clear to a person skilled in the art that, in general principle, the terminal opposite to the one connected to the inverter input can be maintained at any desired potential.

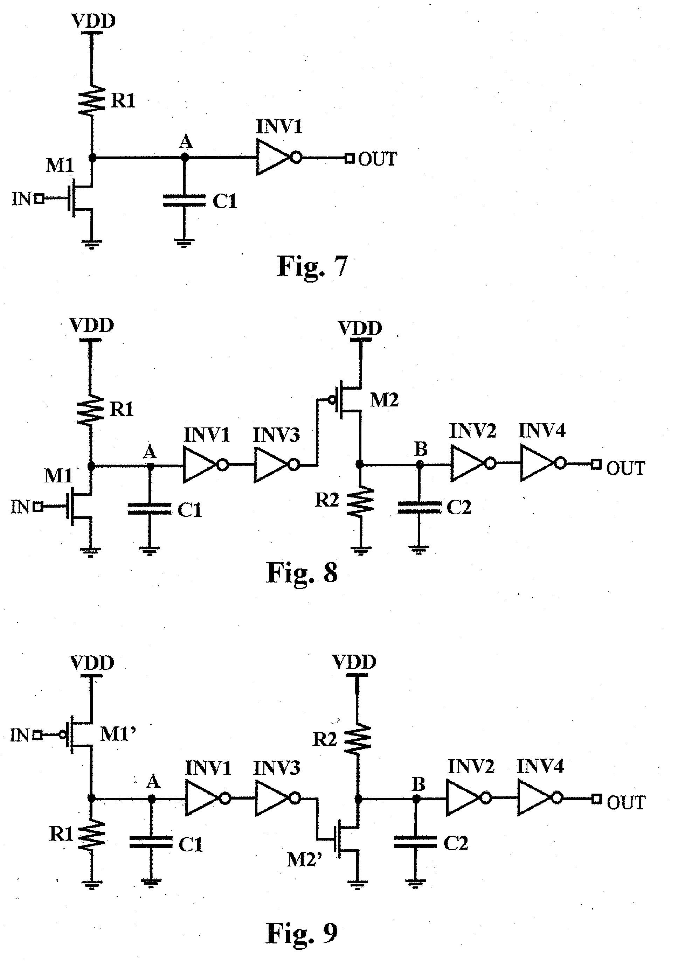

A likewise known variant of the time-delay circuit of Figure 1 is shown in Figure 7. In this circuit the constant current generator is substituted by a resistor R1, so that the time delay is a function of the product of the resistance of the resistor R1 multiplied by the capacitance of the capacitor C1.

Referring to Figure 2, let us consider as input signal IN of the circuit of Figure 1 a clock signal, i.e. a periodic succession of voltage pulses that vary in steps between a low value, ground potential for example (binary state 0), and a given positive voltage, VDD for example (binary state 1). When IN=1, the transistor M1 is conducting, so that the connection node A between the drain terminal of M1 and the generator G1 is substantially at ground potential (binary state 0), the condenser C1 is discharged and, due to the effect of the inverter INV1, the output OUT of the delay circuit is a positive voltage, typically the supply voltage VDD. When the input signal IN passes from 1 to 0, the transistor M1 stops conducting and the capacitor C1 commences charging through the generator G1. When the voltage on the node A reaches the threshold voltage that makes the inverter switch, the output OUT of the time-delay circuit passes from the voltage VDD to ground potential. The time Δt1 that elapses between the moment the trailing edge of the signal IN changes from 1 to 0 and the switching of the inverter, i.e. the delay time of the circuit, obviously depends not only on the current I of the generator G1 and the capacitance of the capacitor C1, but also on the threshold voltage of the inverter. The inverter is typically constituted by two complementary MOS transistors (i.e. an N-channel transistor and a P-channel transistor) that have a common drain terminal, while their source terminals are connected, respectively, to the ground terminal and the positive terminal VDD of the supply source. In this case the threshold voltage depends on the supply voltage VDD, the threshold voltages of the transistors and the mobility of the charge carriers (electrons and vacancies) of the transistors. The supply voltage VDD may be fixed with a good degree of precision (+/-1%) at a nominal value established in the design phase, but the threshold voltages of the transistors and the mobility of the charge carriers cannot be accurately fixed, because they depend on manufacturing parameters, which may vary within relatively wide limits, and depend also on the operating temperature, which - in its turn - depends on the operating conditions of the device in which the time-delay circuit is integrated. According to the prior art, if these difficulties are to be at least partially avoided, the designer has to adopt some rather complex measures that, for this very reason, go to the detriment of the simplicity of the circuit and occupy a not by any means negligible area of the integrated circuit.

The principal aim of the present invention is to propose a time-delay circuit of the type defined above, i.e. simple in structure and capable of being integrated in a small area, that generates a delay substantially insensitive to the variation of the manufacturing parameters and the operating temperature of the integrated circuit.

This object is attained by realizing the time-delay circuit defined and characterized in general terms by Claim 1 hereinbelow, of which some specific embodiments are defined by the dependent claims.

The invention will be more clearly understood from the following detailed descriptions of some embodiments thereof, the description making reference to the attached drawings, of which
Figures 1 and 7 show two time-delay circuits in accordance with the prior art,
Figure 2 shows the input and output waveforms of the circuit of Figure 1,
Figures 3 and 5 show two embodiments of the time-delay circuit in accordance with the invention,
Figures 4 and 6 show the input and output waveforms of the circuits of, respectively, Figures 3 and 5,
Figures 8 and 9 show two further embodiments of the time-delay circuit in accordance with the invention and
Figures 10 and 11 show, respectively, a graph and a table that illustrate the operation of the circuits of Figures 8 and 9.

Referring to Figures 3 and 4, the circuit in accordance with the invention comprises an input stage, wholly equal to the circuit of Figure 1, that is coupled, by means of an inverter INV3, to a second stage that comprises a dual circuit of the one of Figure 1. More particularly, the second stage comprises a P-channel MOS transistor, indicated by M2, having its source terminal connected to the positive terminal VDD of the supply source and its drain terminal (node B) connected, via a constant current generator G2, to the negative terminal of the supply source, i.e. the ground terminal. The node B is connected to ground via a capacitor C2 and to the output terminal OUT of the circuit via two inverters INV2 and INV4 in cascade.

Referring now also to Figure 4, when the input terminal IN is equal to 1, the transistor M1 is conducting, the node A is at 0, the capacitor C1 is discharged, the output of the inverter INV1 is at 1, the output of the inverter INV3 is at 0, the transistor M2 is conducting, the node B is at 1, the capacitor C2 is charged at the voltage VDD, the output of the inverter INV2 is at 0 and the output OUT is at 1. When the input IN switches from 1 to 0, i.e. when M1 passes from conducting to blocking, the current I1 of the generator G1 charges the capacitance C1, causing the voltage of the node A to rise linearly (VA=I1*t/C1, where t is the time and C1 is the capacitance of the capacitor C1). When, following a time Δt1, the threshold voltage of the inverter INV1 is attained, the output of the inverter switches from 1 to 0, the output of the inverter INV3 switches from 0 to 1, the transistor M2 switches to blocking and the capacitor C2 becomes linearly discharged (VB=VDD-I2*t/C2, where t is the time, C2 is the capacitance of the capacitor C2 and I2 is the current of the generator G2). When, following a time Δt2, the node B reaches the threshold voltage of the inverter INV2, the latter switches from 0 to 1 and the output OUT switches from 1 to 0. The time At that elapses between the moment the trailing edge of the signal IN changes from 1 to 0 and the switching of the inverter INV4 is the delay time of the circuit and is substantially given by the sum of the two delays Δt1 and Δt2, i.e. the sum of the time that is needed for the current I1 to charge the capacitor C1 from 0 (ground potential) to the threshold voltage Vth (INV1) of the inverter INV1 and the time that is needed for the current I2 to discharge the capacitor C2 from the voltage VDD to the threshold voltage Vth (INV2) of the inverter INV2. When the circuit is designed in such a manner that I1=I2=I, C1=C2=C, Vth (INV1)=Vth(INV2), the total delay time of the circuit is determined solely by the time needed for a constant current I to charge a capacitor of capacitance C from 0 to VDD. The delay time is thus independent of the threshold voltage of the inverters and therefore insensitive to the variations deriving from the manufacturing process and the temperature. There remains the dependence on the supply voltage, but, as already mentioned, this can easily be maintained at a substantially constant nominal value.

As is well known to persons skilled in the design of integrated circuits, the conditions of equality indicated above can be obtained with a good degree of precision. In particular, the generators G1 and G2 may be constituted by branches of respective equal current mirrors that mirror a fixed reference current independent of the temperature and the inverters may be constituted by identical components, since they are of the same size and are made by means of the same manufacturing process. It is in any case clear to a person skilled in the art that the same result may, as a general rule, be obtained with different current generators, capacitors and inverters, always provided that the equalities I1/C1=I2/C2 and Vth(INV1)=Vth(INV2) are substantially satisfied.

It is obvious that the inverter INV4 serves only for obtaining at the output terminal a clock signal having the same sign as the input signal. When a clock signal of the opposite sign is desired, this inverter may be omitted: in that case the output of the circuit coincides with the output of the inverter INV2.

Figure 5 shows a dual circuit of the one shown in Figure 3. It differs from this latter circuit by virtue of the fact that, rather than an N-channel MOS transistor, it utilizes a P-channel MOS transistor, indicated in the figure by M1' , and, rather than a P-channel MOS transistor , an N-channel transistor, indicated by M2', and also by virtue of the fact that these transistors have their respective source terminals connected to the supply terminals dual to those of the corresponding transistors of the circuit of Figure 3. With this configuration the delay time At of the output OUT is relative to the leading edge of the input signal IN, as is shown in Figure 6. The functioning of this circuit is wholly analogous to the functioning of the circuit of Figure 3, for which reason it will not here be further described.

The circuits of Figures 8 and 9 differ from those of Figures 3 and 5, respectively, by virtue of the fact that the constant current generators G1 and G2 are substituted by two resistors, respectively R1 and R2. In this case, once again, the delay time is given by the sum of the delays of the two stages, each of which is a function of the product R1C1 and R2C2 of the respective resistances and capacitances.

The circuit of Figure 8 produces a delay with respect to the trailing edge and the circuit of Figure 9 produces a delay with respect to the leading edge like the circuits of, respectively, Figure 3 and Figure 4 and as shown, respectively, in Figure 4 and Figure 6.

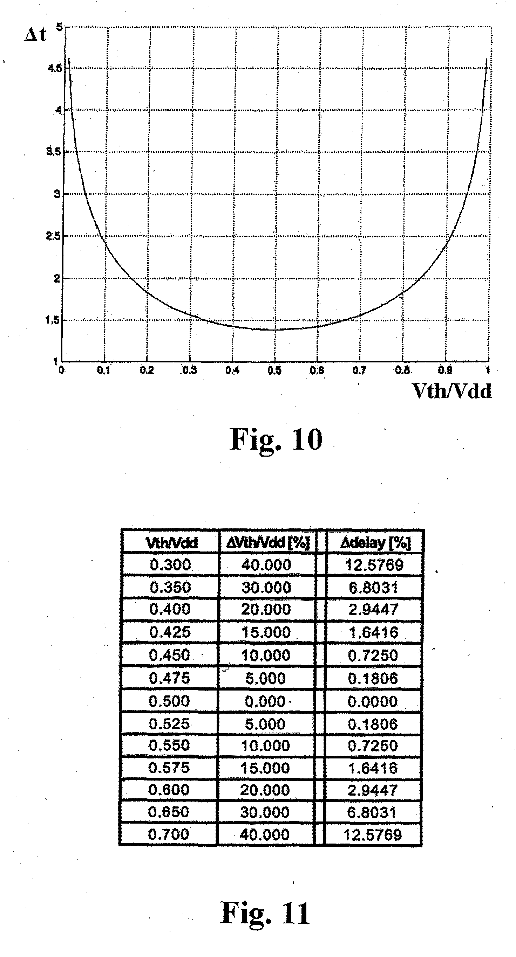

Since the voltage of the capacitors varies in an exponential manner in time when the capacitors become charged and discharged, the delays generated in the two stages are equal to each other only when the threshold voltages of the two inverters are exactly equal to half the supply voltage. Only in that case, in fact, the time needed to charge the capacitor C1 from 0 to VDD/2 and to discharge the capacitor C2 from VDD to VDD/2 will be the same when R1=R2 and C1=C2. Naturally, the threshold voltages can be fixed at exactly the nominal value VDD/2 during the design phase. In actual practice, nevertheless, the threshold voltages may differ within wide limits from the nominal value on account of the variability of the manufacturing parameters, and the delay times generated in the two stages may therefore differ from each other. As a general rule, therefore, the compensation obtained will not be complete and the total delay time, given by the sum of the two delays, depends to some extent on the effective threshold voltage. It can easily be shown, however, that this compensation will nevertheless be very substantial within a very wide range of variability of the threshold voltage. This conclusion can be verified by examining the curve of Figure 10 in combination with the table of Figure 11, where Vth/Vdd indicates the ratio between the threshold voltage Vth and the supply voltage Vdd, At indicates the total delay time, ΔVth/Vdd[%] indicates the percentage variation of the ratio Vth/Vdd and Δdelay[%] indicates the percentage variation of the total delay.

As can easily be noted, the object of the invention is fully attained, because the delay-time circuits that can be realized in accordance with the invention make it possible to obtain delay times that are independent of the variation of the manufacturing parameters and the operating temperatures, or depend on them only to a negligible extent, in a simple manner and with a minimum occupation of the integration area.

## Claims

1. A time-delay circuit comprising
- an input terminal (IN) and an output terminal (OUT),
- a first inverter (INV1) having a switching threshold voltage,
- a first capacitor (C1) connected to the input terminal of the first inverter,
- means (M1, G1) for controlling the charge of the first capacitor (C1) capable of responding to a predetermined edge of a pulse applied to the input terminal (IN) of the circuit by bringing the input terminal of the first inverter (INV1) from a first predetermined voltage to the switching threshold voltage and obtaining on the output terminal of the first inverter a pulse having an edge that, as referred to the predetermined edge of the input pulse, has a first delay time that depends on the switching voltage threshold,
**characterized in that** it comprises a stage having an input terminal coupled to the output terminal of the first inverter (INV1) and an output terminal coupled to the output terminal (OUT) of the circuit, said stage comprising
- a second inverter (INV2) having a switching threshold voltage substantially equal to that of the first inverter (INV1) and an output terminal that is the output terminal of the stage,
- a second capacitor (C2) connected to the input terminal of the second inverter (INV2) and
- means (M2, G2) for controlling the charge of the second capacitor (C2) capable of responding to the retarded edge of the pulse present on the output terminal of the first inverter (INV1) by bringing the input terminal of the second inverter from a second predetermined voltage to the switching threshold voltage and obtaining on the output terminal of the second inverter (INV2) a pulse having an edge that, as referred to the retarded edge of the output pulse of the first inverter, has a second delay time that depends on the switching threshold voltage, the overall delay of the circuit being the sum of the first and the second delay time.

2. A time-delay circuit in accordance with Claim 1
- wherein the input terminal of the stage is coupled to the output terminal of the first inverter (INV1) by means of a third inverter (INV3),
- wherein the means for controlling the charge of the first capacitor (C1) comprise a first constant current generator (G1) and a first controlled electronic switch (M1) connected in series with each other between a first and a second supply terminal of the circuit, said first controlled electronic switch (M1) having a control terminal connected to the input terminal (IN) of the circuit, and
- wherein the means for controlling the charge of the second capacitor (C2) comprise a second constant current generator (G2) and a second controlled electronic switch (M2) connected in series with each other between the second and the first supply terminal, said second controlled electronic switch (M2) having its control terminal connected to the output terminal of the third inverter (INV3).

3. A time-delay circuit in accordance with Claim 2, wherein the first and the second constant current generator (G1, G2) and the first and the second capacitor (C1, C2) are dimensioned in such a manner that the ratio between the capacitance of the first capacitor (C1) and the current (I1) of the first generator (G1) is substantially equal to the ratio between the capacitance of the second capacitor (C2) and the current (I2) of the second generator (G2).

4. A time-delay circuit in accordance with Claim 3, wherein the first capacitor (C1) and the second capacitor (C2) have substantially the same capacitance and the first generator (G1) and the second generator (G2) generate substantially equal currents.

5. A time-delay circuit in accordance with Claim 1,
- wherein the input terminal of the stage is coupled to the output terminal of the first inverter (INV1) via a third inverter (INV3),
- wherein the means for controlling the charge of the first capacitor C1) comprise a first resistor (R1) and a first controlled electronic switch (M1) connected in series with each other between a first and a second supply terminal of the circuit, said first controlled electronic switch (M1) having a control terminal connected to the input terminal (IN) of the circuit and
- wherein the means for controlling the charge of the second capacitor (C2) comprise a second resistor (R2) and a second controlled electronic switch (M2) connected in series with each other between the second and the first supply terminal, said second controlled electronic switch (M2) having its control terminal connected to the output terminal of the third inverter (INV3) .

6. A time-delay circuit in accordance with Claim 5, wherein the first capacitor (C1) and the second capacitor (C2) have substantially the same capacitance and the first resistor (R1) and the second resistor (R2) have substantially the same resistance.

7. A time-delay circuit in accordance with any one of Claims 2 to 6, wherein the first and the second controlled electronic switch comprise, respectively, an N-channel MOS transistor (M1) and a P-channel MOS transistor (M2).
